Europäisches Patentamt

European Patent Office

Office européen des brevets

(19)

(11) Numéro de publication: **0 029 376**
**B1**

(12) **FASCICULE DE BREVET EUROPEEN**

(45) Date de publication du fascicule du brevet: **11.07.84**

(51) Int. Cl.³: **H 03 D 3/00, H 04 N 9/40**

(21) Numéro de dépôt: **80401542.8**

(22) Date de dépôt: **30.10.80**

(54) **Procédé de démodulation d'un signal modulé en fréquence et démodulateur mettant en oeuvre ce procédé.**

(30) Priorité: **14.11.79 FR 7928043**

(43) Date de publication de la demande:
**27.05.81 Bulletin 81/21**

(45) Mention de la délivrance du brevet:
**11.07.84 Bulletin 84/28**

(84) Etats contractants désignés:
**DE GB LU**

(56) Documents cités:
**FR - A - 2 433 756**
**US - A - 3 956 623**
**US - A - 4 090 145**

**ELECTRONICS LETTERS, vol. 15, no. 16, 2 août 1979 Londres GB COUPE: "Digital Frequency Discriminator", pages 489-490**

(73) Titulaire: **THOMSON-CSF**
**173, Boulevard Haussmann**
**F-75379 Paris Cedex 08 (FR)**

(72) Inventeur: **Marguinaud, André**
**"THOMSON-CSF" SCPI 173, Bld Haussmann**
**F-75360 Paris Cedex 08 (FR)**
Inventeur: **Artigalas, Max**
**"THOMSON-CSF" SCPI 173, Bld Haussmann**
**F-75360 Paris Cedex 08 (FR)**
Inventeur: **Remy, Maurice**
**TELEDIFFUSION DE FRANCE 21-27, rue Barbès**
**F-92129 Montrouge (FR)**
Inventeur: **Sabatier, Jacques**
**TELEDIFFUSION DE FRANCE 21-27, rue Barbès**
**F-92129 Montrouge (FR)**

(74) Mandataire: **Turlèque, Clotilde et al,**
**THOMSON-CSF SCPI 173, Bld Haussmann**
**F-75379 Paris Cedex 08 (FR)**

Courier Press, Leamington Spa, England.

## Description

La présente invention concerne les procédés de démodulation d'un signal modulé en fréquence, les démodulateurs mettant en oeuvre ces procédés, et en particulier les systèmes de télévision SECAM comportant de tels démodulateurs.

Dans le système SECAM les informations de couleur modulent en fréquence une sous-porteuse située au voisinage de l'extrémité des fréquences les plus élevées et à l'intérieur du spectre de luminance. Ce dernier s'étend de 0 à 6 MHz environ et la sous-porteuse, dont l'excursion de fréquence s'étend entre 3,9 et 4,7 MHz, est mélangée au spectre principal. Divers systèmes ont été imaginés pour démoduler cette sousporteuse à l'aide de discriminateurs de fréquence classiques qui présentent l'inconvénient d'être sensible aux variations d'amplitude du signal à traiter. Classiquement les décodeurs SECAM réalisent les fonctions suivantes; désaccentuation haute fréquence (courbe anticloche) compensant la mise en forme réalisée au codage (courbe en cloche), limitation d'amplitude éliminant l'influence des variations d'amplitude (sur le descriminateur de fréquence), et démodulation par un discriminateur. Ce principe est exposé notamment dans Radio Télévision n° 2.80, page 44, paragraphe 4.7.3, Télédiffusion de France 1980. Ce principe de réalisation d'un décodeur SECAM découle de l'utilisation des discriminateurs de fréquences de type classique, qui sont sensibles aux variations d'amplitude du signal.

Les brevets US 4 090 145 et 3 956 623 décrivent des démodulateurs numériques, comportant des déphaseurs, qui nécessitent que le signal ait une porteuse, ce qui n'est pas le cas pour le signal SECAM. La demande de brevet FR 2 433 756, publiée le 14 mars 1980, décrit un dispositif qui nécessite une fréquence d'échantillonnage 16 fois supérieure à celle du signal, pour pouvoir assimiler une petite variation du signal à sa dérivée. Il nécessiterait donc une fréquence d'échantillonnage très élevée pour décoder un signal SECAM, par conséquent sa mise en oeuvre n'est pas envisageable pour démoduler un signal SECAM.

La présente invention présente l'intérêt de pouvoir effectuer une démodulation en numérique d'un signal modulé en fréquence, en particulier d'un signal de chrominance d'un signal vidéo SECAM, tout en présentant l'avantage de ne pas être sensible aux variations d'amplitude du signal à fréquence faible par rapport à la fréquence centrale. Il est alors possible de ne pas utiliser de limitation d'amplitude, ni de désaccentuation haute fréquence. L'absence de filtre de désaccentuation est un avantage très important car il n'y a plus de réglage à effectuer et le discriminateur peut être entièrement intégré, d'où un abaissement de son coût.

Selon l'invention, un procédé de démodulation d'un signal modulé en fréquence autour d'une fréquence F et ayant une bande passante petite par rapport à F, est caractérisé en ce que le signal est échantillonné à un rythme égal à 4F', F' étant une fréquence quelconque de la bande de fréquence du signal; en ce qu'il est calculé le rapport N/D d'une première combinaison linéaire

$$N = x\left(t_1 - \frac{3}{4F'}\right) - x(t_1) - x\left(t_1 - \frac{2}{4F'}\right) + x\left(t_1 - \frac{1}{4F'}\right)$$

et d'une deuxième combinaison linéaire

$$D = 2 \cdot x\left(t_1 - \frac{2}{4F'}\right) - 2 \cdot x\left(t_1 - \frac{1}{4F'}\right)$$

de 4 échantillons successifs:

$$x(t_1), \; x\left(t_1 - \frac{1}{4F'}\right), \; x\left(t_1 - \frac{2}{4F'}\right), \; x\left(t_1 - \frac{3}{4F'}\right),$$

du signal à démoduler; et en ce qu'il est calculé

$$\frac{2F'}{\pi} \; \arcsin\left(\frac{N}{D}\right),$$

valeur correspondant à la valeur de la variation de fréquence ΔF du signal modulé.

Selon l'invention, il est également prévu des démodulateurs pour mettre en oeuvre ce procédé.

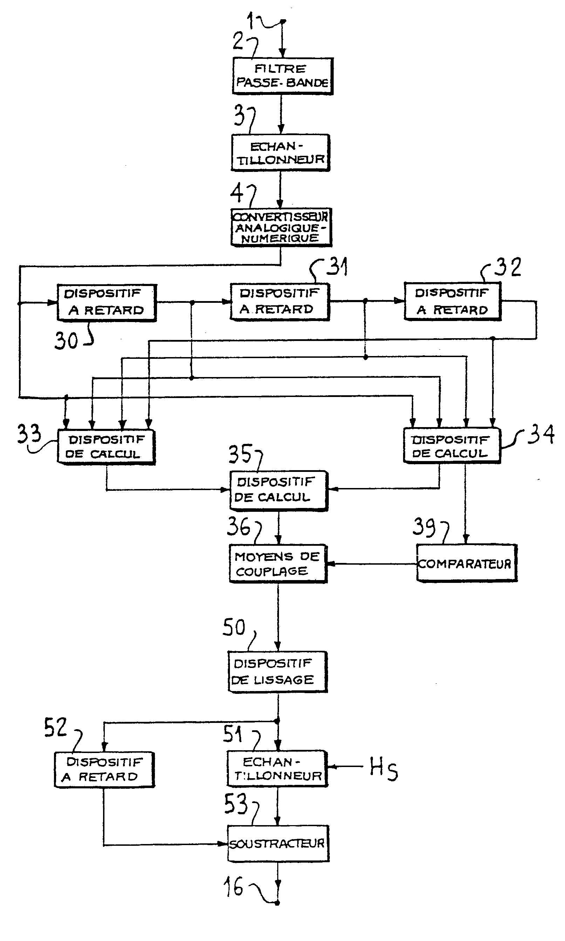

L'invention sera mieux comprise et d'autres caractéristiques apparaîtront à l'aide de la description ci-après et de la figure s'y rapportant qui représente le schéma synoptique d'un exemple de réalisation du démodulateur numérique selon l'invention.

Dans cette figure, les dispositifs de synchronisation précise, relevant de la technologie courante, n'ont pas été représentés en vue de rendre le dessin plus clair et de simplifier l'exposé.

Sur cette figure, une borne d'entrée 1 est couplée à l'entrée d'un convertisseur analogique numérique 4 à travers un filtre 2 en série avec un échantillonneur 3. La sortie du convertisseur 4 est couplée à chacune des premières entrées d'un premier dispositif de calcul 33 et d'un deuxième dispositif de calcul 34 à l'entrée d'un premier dispositif à retard 30. La sortie de ce dispositif à retard 30 est reliée à l'entrée d'un deuxième dispositif à retard 31 et à chacune des deuxièmes entrées des dispositifs de calcul 33 et 34. La sortie de ce dispositif à retard 31 est couplée à chacune des troisièmes entrées des dispositifs de calcul 33 et 34 et à chacune des quatrièmes entrées de ces dispositifs 3 et 34 à travers un troisième dispositif à regard 32. La sortie du dispositif de calcul 33 et une première sortie du dispositif de calcul 34 sont respectivement reliées à une première entrée et à une deuxième entrée d'un troisième dispositif de calcul 35. La sortie de ce dispositif 35 est reliée à l'entrée d'un dispositif de lissage 50 à travers des moyens de couplage 36 ayant une entrée de commande couplée à une deuxième sortie du dispositif de calcul 34 à travers un comparateur de seuil 39. La sortie du dispositif de lissage 50 est couplée à une première entrée d'un soustracteur 53 à travers un échantillonneur 51 et à une deuxième entrée de ce soustracteur 53 à travers un quatrième dispositif à retard 52. La sortie du soustracteur 53 est réliée à une borne de sortie 16.

Les principaux résultats théoriques qui ont permit de réaliser le démodulateur représenté sur cette figure sont donnés ci-apprès.

Il peut être considéré, dans un repère Oxy, un vecteur x(t) représentatif d'une sinusoïde dont on veut estimer la fréquence.

Soient quatre valeurs de x(t) obtenues à des intervalles de temps réguliers égaux à

$$\frac{1}{4F} \, ;$$

par exemple

$$x(t_1), x(t_1 - \frac{1}{4F}), x(t_1 - \frac{2}{4F}), x(t_1 - \frac{3}{4F}),$$

$t_1$ étant un instant quelconque. L'expression de ces quatre échantillons

$$x(t_1 - \frac{i}{4F}),$$

i variant de 0 à 3 est la suivante:

$$x(t_1 - \frac{i}{4F}) = \cos [\omega(t_1 - \frac{i}{4F}) + \psi_0]$$

$$= \cos [\theta(t_1) - \frac{i\omega}{4F}] \tag{4}$$

avec $\omega: 2\pi(F + \Delta F)$.

A partir de cette formule (4), il est possible de calculer $\Delta F$ d'après la formule (5) suivante:

$$\Delta F = \frac{2F}{\pi} \arcsin \left[ \frac{x(t_1 - \frac{3}{4F}) - x(t_1) - x(t_1 - \frac{2}{4F}) + x(t_1 - \frac{1}{4F})}{2x(t_1 - \frac{2}{4F}) - 2x(t_1 - \frac{1}{4F})} \right]$$

$$= \frac{2F}{\pi} \arcsin (\frac{N}{D}) \tag{5}$$

à condition que:

$$2x(t_1 - \frac{2}{4F}) - 2x(t_1 - \frac{1}{4F}) \neq 0, |\frac{N}{D}| \leqslant 1 \tag{6}$$

3

En pratique, il suffit d'échantillonner le signal de chrominance à un rythme égal à quatre fois la fréquence F, de stocker les échantillons, et de calculer $\Delta F$ par la formule (5).

Le fonctionnement du dispositif décrit sur la figure est le suivant:

Le signal vidéo SECAM reçu sur la borne d'entrée 1 est traité de façon à obtenir à la sortie du convertisseur 4 des échantillons numériques x(t) du signal de chrominance suivant une fréquence

$$\frac{1}{4F}.$$

Chacun de ces échantillons est ensuite introduit dans les dispositifs à retard 30, 31 et 32 pour obtenir à un instant $t_1$ quelconque à la fois l'échantillon $x(t_1)$ et les échantillons

$$x(t_1 - \frac{1}{4F}), \, x(t_1 - \frac{2}{4F}), \, x(t_1 - \frac{3}{4F}).$$

A partir de ces valeurs, les dispositifs de calcul 33 et 34 calculent respectivement les valeurs N et D de la formule (5). De même à chaque instant d'échantillonnage le dispositif de calcul 35 délivre $\Delta F$ d'après la formule (5). Le comparateur 39 permet de comparer $|D|$ à S' (S' positif), la valeur S' représente la valeur du seuil en dessous duquel l'approximation de arc sin

$$(\frac{N}{D})$$

est mauvaise ($|D|$ petit). Lorsque $|D|$ est supérieur à S' et à cette seule condition, le comparateur 39 commande les moyens de couplage 36 pour coupler la sortie du dispositif 35 à l'entrée du filtre 21 et laisser passer les échantillons numériques $\Delta F$.

Les éléments 50, 51, 52 et 53 permettent de générer sur la borne de sortie 16, les valeurs numériques de l'excursion de fréquence pour pourvoir reconstituer le signal démodulé.

L'invention n'est pas limitée au mode de réalisation décrit et représenté; de nombreuses variantes de réalisation sont possibles.

En particulier, les dispositifs à retard 30, 31 et 32, les dispositifs de calcul 33, 34 et 35, le comparateur 39 et les moyens de couplage 36 peuvent être réalisés à l'aide de dispositifs à transfert de charge, le convertisseur analogique numérique 4 étant supprimé.

Dans le mode de réalisation décrit il a été choisi d'échantillonner le signal de chrominance à un rythme égal à 4 fois la fréquence F égale à 4,3 MHz. Mais cette valeur F n'est pas restrictive, toute valeur de fréquence F' comprise dans la bande de fréquence du signal de chrominance convient.

De plus, la valeur du rythme d'échantillonnage peut être choisie égale à q fois la fréquence F' (q réel positif), la formule (5) est alors remplacée par la formule générale suivante:

$$\Delta F = \frac{qF'}{2\pi} \text{ arc sin } (\frac{N}{D}) - F'(1 - \frac{q}{4}).$$

Cette formule générale est applicable pour un nombre quelconque d'échantillons, N et D étant des combinaisons linéaires d'échantillons successifs.

Il est aussi à remarquer que sur la figure les positions respectives du filtre 2, de l'échantillonneur 3, du convertisseur analogique numérique 4 peuvent être interverties.

Enfin, il est important de noter que l'invention est applicable à partir de tout signal modulé en fréquence, pourvu que la bande de fréquence du signal soit petite par rapport à la fréquence centrale.

## Revendications

1. Procéde de démodulation d'un signal modulé en fréquence autour d'une fréquence F et ayant une bande passante petite par rapport à F, caractérisé en ce que le signal est échantillonné à un rythme égal à 4F', F' étant une fréquence quelconque de la bande de fréquence du signal; en ce qu'il est calculé le rapport N/D d'une première combinaison linéaire

$$N = x(t_1 - \frac{3}{4F'}) - x(t_1) - x(t_1 - \frac{2}{4F'}) + x(t_1 - \frac{1}{4F'})$$

et d'une deuxième combinaison linéaire

$$D = 2 \cdot x(t_1 - \frac{2}{4F'}) - 2 \cdot x(t_1 - \frac{1}{4F'})$$

de 4 échantillons successifs:

$$x(t_1), x(t_1 - \frac{1}{4F'}), x(t_1 - \frac{2}{4F'}), x(t_1 - \frac{3}{4F'}),$$

du signal à démoduler; et en ce qu'il est calculé

$$\frac{2F'}{\pi} \text{ arc sin } (\frac{N}{D}),$$

valeur correspondant à la valeur de la variation de fréquence $\Delta F$ du signal modulé.

2. Démodulateur d'un signal modulé en fréquence autour d'une fréquence F et ayant une bande passante petite par rapport à F, mettant en oeuvre le procédé de la revendication 1, caractérisé en ce qu'il comporte: un échantillonneur (3) échantillonnant le signal modulé à une fréquence 4F'; un convertisseur analogique-numérique (4) des échantillons sélectionnés par l'échantillonneur (3); un ensemble (30, 31 et 32) de 3 dispositifs à retard, de retard $\theta$ égal à

$$\frac{1}{4F'},$$

couplés en série, ledit ensemble ayant une entrée couplée à la sortie du convertisseur (4) et une sortie, lesdits dispositifs à retard ayant chacune une entrée et une sortie; un premier (33) et un deuxième (34) dispositif de calcul ayant chacun 4 entrées respectivement couplées aux 3 entrées des 3 dispositifs à retard et à la sortie de l'ensemble des 3 dispositifs à retard, et ayant chacun une sortie pour délivrer respectivement les valeurs N et D; un troisième dispositif de calcul (35) dont les entrées sont reliées respectivement aux sorties des premier et deuxième dispositifs de calcul (33, 34) et ayant une sortie pour délivrer la valeur de la variation de fréquence $\Delta F$ égale à

$$\frac{2F'}{\pi} \text{ arc sin } (\frac{N}{D}) ;$$

un comparateur (39) de la valeur absolue de D par rapport à un seuil prédéterminé S' (S' réel positif); et des moyens de couplage (36) ayant une entrée couplée à la sortie du troisième dispositif de calcul (35), une entrée de commande couplée à la sortie du comparateur (39), et une sortie pour délivrer $\Delta F$ lorsque la valeur absolue de D est supérieure au seuil S'.

3. Démodulateur selon la revendication 2, caractérisé en ce que les dispositifs à retard (30, 31, 32), les dispositifs de calcul (33, 34, 35), le comparateur (39) et les moyens de couplage (36) sont constitués par des dispositifs à transfert de charge (D.T.C.)

**Patentansprüche**

1. Verfahren zur Demodulation eines um eine Frequenz F frequenzmodulierten Signals, dessen Durchlaßband klein gegenüber F ist, dadurch gekennzeichnet, daß das Signal in einem Rhythmus abgetastet wird, der gleich 4F' ist, worin F' eine beliebige Frequenz des Signalfrequenzbandes ist; daß das Verhältnis N/D einer ersten Linearkombination

$$N = x(t_1 - \frac{3}{4F'}) - x(t_1) - x(t_1 - \frac{2}{4F'}) + x(t_1 - \frac{1}{4F'})$$

zu einer zweiten Linearkombination

$$D = 2 \cdot x(t_1 - \frac{2}{4F'}), \quad -2 \cdot x(t_1 - \frac{2}{4F'})$$

von vier aufeinanderfolgenden Abtastproben:

$$x(t_1), x(t_1 - \frac{1}{4F'}), x(t_1 - \frac{2}{4F'}), x(t_1 - \frac{3}{4F'})$$

des zu demodulierenden Signals berechnet wird; und daß

$$\frac{2F'}{\pi} \arcsin \left(\frac{N}{D}\right)$$

berechnet wird, wobei dieser Wert dem Wert der Frequenzänderung ΔF des modulierten Signals entspricht.

2. Demodulator zur Demodulation eines um eine Frequenz F frequenzmodulierten Signals, dessen Durchlaßband klein gegenüber F ist, zur Durchführung des Verfahrens nach Anspruch 1, dadurch gekennzeichnet, daß er umfaßt: Einen Abtaster (3), welcher das modulierte Signal mit einer Frequenz 4F' abtastet; einem Analog/Digital-Umsetzer (4) zur Umsetzung der durch den Abtaster (3) ausgewählten Abtastproben; eine Gruppe (30, 31 und 32) von drei verzögerungsvorrichtungen, deren Verzögerung $\theta$ gleich 1/4F' ist und die in Reihe geschaltet sind, wobei diese Gruppe einen mit dem Ausgang des Umsetzers (4) verbundenen Eingang und einen Ausgang aufweist und wobei diese Verzögerungsvorrichtungen jeweils einen Eingang und einen Ausgang aufweisen; eine erste (33) sowie eine zweite Rechenvorrichtung (34), die jeweils vier Eingänge besitzen, von denen je einer mit einem der drei Eingänge der drei Verzögerungsvorrichtungen und einer mit dem Ausgang der Gruppe von drei Verzögerungsvorrichtungen verbunden ist, und die jeweils einen Ausgang zum Abgeben des Wertes N bzw. D besitzen; eine dritte Rechenvorrichtung (35), deren Eingänge mit den Ausgängen der ersten bzw. zweiten Rechenvorrichtung (33, 34) verbunden sind und die einen Ausgang zum Abgeben des Wertes der Frequenzänderung ΔF aufweist, der gleich

$$\frac{2F'}{\pi} \arcsin \left(\frac{N}{D}\right)$$

ist, einen Komparator (39) zum Vergleichen des Absolutwertes von D mit einem vorbestimmten Schwellwert S' (S' reell und positiv) und Kopplungsmittel (36) mit einem an den Ausgang der dritten Rechenvorrichtung (35) angekoppelten Eingang, einem an den Ausgang des Komparators (39) angekoppelten Steuereingang und einem Ausgang zum Abgeben von ΔF, wenn der Absolutwert von D größer als der Schwellwert S' ist.

3. Demodulator nach Anspruch 2, dadurch gekennzeichnet, daß die Verzögerungsvorrichtungen (30, 31, 32), die Rechenvorrichtungen (33, 34, 35), der Komparator (39) und die Kopplungsmittel (36) durch Ladungsverschiebevorrichtungen (CCD) gebildet sind.

**Claims**

1. Method of demodulating a signal which is frequency modulated about a frequency F and has a passband which is small in comparison to F, characterized in that the signal is sampled at a rhythm which is equal to 4F', F' being an arbitrary frequency of the frequency band of the signal; in that one calculates the ratio N/D of a first linear combination

$$N = x(t_1 - \frac{3}{4F'}) - x(t_1) - x(t_1 - \frac{2}{4F'}) + x(t_1 - \frac{1}{4F'})$$

and a second linear combination

$$D = 2 \cdot x(t_1 - \frac{2}{4F'}), - 2 \cdot x(t_1 - \frac{1}{4F'})$$

of four successive samples:

$$x(t_1), x(t_1 - \frac{1}{4F'}), x(t_1 - \frac{2}{4F'}), x(t_1 - \frac{3}{4F'})$$

of the signal to be demodulated; and in that one calculates

$$\frac{2F'}{\pi} \arcsin \left(\frac{N}{D}\right)$$

this value corresponding to the value of the frequency variaiton ΔF of the modulated signal.

2. Demodulator for demodulating a signal which is frequency modulated about a frequency F and has a passband which is small in comparison to F, for performing the method of claim 1, characterized in that it comprises: A sampler (3) sampling the modulated signal at a frequency 4F'; a digital analog converter (4) for converting the samples selected by the sampler (3); a set (30, 31 and 32) of three series connected delay devices having a delay θ which is equal to 1/4F', said set having an input coupled to the output of the converter (4) and an output, said delay devices each having an input and an output; a first (33) and a second (34) computing device each having four inputs respectively coupled to the three inputs of the three delay devices and to the output of the set of three delay devices, and each having an output for respectively supplying the values N and D; a third computing device (35) the inputs of which are respectively connected to the outputs of the first and second computing devices (33, 34) and having an output for supplying the value of the frequency variation ΔF which is equal to

$$\frac{2F'}{\pi} \arcsin \left(\frac{N}{D}\right)$$

a comparator (31) for comparing the absolute value of D to a predetermined threshold S' (S' being a positive real number); and coupling means (36) having an input coupled to the output of the third computing device (35), a control input coupled to the output of the comparator (39) and an output for supplying ΔF when the absolute value of D exceeds the threshold S'.

3. Demodulator according to claim 2, characterized in that the delay devices (30, 31, 32), the computing devices (33, 34, 35), the comparator (39) of the coupling means (36) are formed of charge transfer devices (CCD).